# FASCICULE DE BREVET EUROPEEN

(11) **EP 0 896 737 B1**
(45) Date de publication et mention de la délivrance du brevet: **13.09.2000**
(21) Numéro de dépôt: 97921906.0
(22) Date de dépôt: 30.04.1997
(51) Int. Cl.: H01L 31/02, H01L 25/16, H02J 7/35

(54) **MODULE PHOTOVOLTAIQUE ET INSTALLATION DE PRODUCTION D'ENERGIE ELECTRIQUE METTANT EN OEUVRE CE MODULE**
PHOTOVOLTAISCHE ANORDNUNG UND MIT DIESER HERGESTELLTE ANLAGE ZUR ERZEUGUNG ELEKTRISCHER ENERGIE
PHOTO-VOLTAIC MODULE AND ELECTRIC ENERGY PRODUCTION INSTALLATION USING THIS MODULE

(30) Priorité: 03.05.1996 FR 9605811
(43) Date de publication de la demande: 17.02.1999
(73) Titulaire: Transenergie, 69130 Ecully (FR)
(72) Inventeur: MOINE, Gérard, F-69440 Mornant (FR)
(74) Mandataire: Vuillermoz, Bruno
(86) Numéro de dépôt international: FR9700764
(87) Numéro de publication internationale: WO9742664

(56) Documents cités:
- EP-A- 0 342 578
- PATENT ABSTRACTS OF JAPAN vol. 013, no. 592 (C-671), 26 Décembre 1989 & JP 01 249154 A (TOSHIBA ELECTRIC EQUIP CORP;OTHERS: 01), 4 Octobre 1989,

## Description

L'invention concerne un module photovoltaïque destiné, de manière connue, à transformer l'énergie solaire en un courant électrique continu.

Elle concerne également une installation de production d'énergie électrique mettant en oeuvre de tels modules. Ces installations mettent en oeuvre comme générateurs d'électricité de tels modules photovoltaïques, et intègrent des dispositifs susceptibles de stocker l'électricité ainsi produite, notamment une ou plusieurs batteries. Cependant, il est également possible d'utiliser immédiatement l'énergie produite au niveau d'un ou de plusieurs récepteurs électriques, après un éventuel traitement.

De telles installations de production et de stockage d'énergie électrique sont tout particulièrement adaptées, notamment dans des lieux isolés, tels que des zones arides, à faible densité de population, etc., où la distribution d'énergie électrique par voie traditionnelle, c'est à dire par réseau s'avère d'un coût prohibitif.

L'usage montre que les modules solaires mis en oeuvre dans ces installations sont fréquemment subtilisés ou volés, afin d'être revendus ou montés en d'autres lieux par ces personnes indélicates.

Afin de s'opposer à ces actes malveillants, on a proposé pour les décourager, d'axer la protection sous l'angle mécanique, notamment par le biais de structures mécano-soudées, réalisées notamment en acier inoxydable, constituant ainsi un ensemble inviolable. Outre le fait, que de tels ensembles sont lourds et nécessitent généralement d'être réalisés en usine, ils affectent également la modularité des installations de production d'énergie électrique mettant en oeuvre ces modules photovoltaïques. On a également proposé de mettre en oeuvre des visseries inviolables faisant appel à des têtes de vis complexes, nécessitant pour leur mise en place comme pour leur retrait des clés spéciales. Dans un cas comme dans l'autre, de telles protections mécaniques s'avèrent ne constituer que de simples retardateurs, leur fonction dissuasive n'étant néanmoins pas suffisante pour faire échec de manière satisfaisante à ces vols.

On a alors proposé des dispositifs électriques ou électroniques, et notamment des systèmes d'alarme, constitués par exemple d'une boucle électrique passant par l'ensemble des modules photovoltaïques mis en oeuvre au sein d'une installation, et qui lorsqu'elle est ouverte, déclenche un signal d'alarme, radio, téléphonique ou visuel ou une combinaison de ces signaux, voir avertit une centrale de gardiennage. On conçoit volontiers que compte-tenu du lieu d'implantation de ces installations, de tels systèmes d'alarme s'avèrent en général inopérants et en tout cas peu dissuasifs.

On a également proposé de mettre en place un repérage ou marquage spécifique au niveau des modules. Ce marquage peut se présenter sous la forme d'une couche indélébile colorée, visible de loin et identifiable au propriétaire de l'installation ou à la compagnie assurant la maintenance et la location de tels modules, ou encore, sous la forme d'un marquage proprement dit. Si certes, ce repérage décourage les éventuels fraudeurs soucieux de procéder à ces vols en vue de la revente des modules, affectant de fait leur intérêt marchand, en revanche, il n'empêche pas une utilisation pour son propre usage.

Enfin, on a également proposé d'intégrer au sein des modules un micro-émetteur, alimenté par l'énergie électrique produite par le module lui-même, et destiné à émettre selon une couverture déterminée, typiquement un rayon d'un kilomètre par rapport au module, un signal susceptible d'être perçu par un récepteur et identifiant ledit module. Certes, ce signal permet de repérer le module. Cependant, celui-ci reste opérationnel, de sorte que ce système s'avère faiblement dissuasif. Par ailleurs, un tel système s'avère relativement coûteux.

On a décrit dans le document EP-A-0 342 578, un régulateur de charge d'accumulateurs photovoltaïque, comprenant dans le circuit de charge, un interrupteur susceptible de gérer la charge desdits accumulateurs. Cependant, un tel interrupteur ne permet pas de s'affranchir des risques de vol desdits accumulateurs, ni de rendre de tels vols dissuasif.

L'objet de l'invention est donc de proposer un module photovoltaïque, destiné à décourager le vol ou même le simple emprunt en rendant le module non fonctionnel.

Ce module photovoltaïque, destiné à transformer l'énergie solaire en courant électrique, notamment continu, comprend deux bornes dites de puissance, sur lesquelles est connecté directement ou indirectement soit une batterie de stockage, soit un récepteur électrique, voire éventuellement les deux.

Il se caractérise en ce qu'il intègre au sein de sa structure un interrupteur électrique susceptible de neutraliser la puissance disponible en sortie aux bornes de puissance, ledit interrupteur étant commandé par un circuit de commande depuis l'extérieur du module.

De la sorte, attendu que cet interrupteur coupe ou met en court-circuit les bornes de sortie du module, et partant neutralise l'alimentation de l'énergie électrique fournie par le module, il rend ce module non fonctionnel, affectant de manière rédhibitoire sa valeur marchande, et réduit à néant toute utilisation éventuelle d'un acquéreur peu scrupuleux.

Avantageusement, cet interrupteur est noyé dans la résine au dos, par exemple de la face active du module, c'est à dire de la face exposée au rayonnement solaire, ou est encapsulé dans la structure sandwich constitutive du module lui-même, de telle sorte que toute tentative d'extraction de l'interrupteur hors du module revient à le rendre définitivement inutilisable.

Cet interrupteur est avantageusement un interrupteur électronique du type transistor à effet de champ réalisé selon la technologie MOS-FET, mais peut également être constitué d'un relai électromécanique, ou tout autre dispositif aboutissant au même résultat.

Dans une version évoluée du module photovoltaïque conforme à l'invention, celui-ci intègre non seulement un interrupteur susceptible de neutraliser la puissance fournie par le module, mais également un ensemble de traitement, c'est à dire un circuit électronique, alimenté par l'énergie électrique produite par le module, et émettant en fonction, par exemple de paramètres de fonctionnement de l'installation au sein de laquelle est mise en place ledit module, un signal de commande agissant au niveau de l'interrupteur.

De la même manière que le cas précédent, la carte électronique constitutive de cet ensemble de traitement est noyée dans la résine ou mise en place au sein d'un boîtier accolé au dos de la face active du module, de sorte que chercher à l'extraire revient à rendre inutilisable ledit module.

L'invention concerne également une installation de production d'énergie électrique. Celle-ci comprend :
- au moins un générateur d'énergie électrique ;
- un circuit électrique de puissance ou d'utilisation, comprenant au moins un récepteur électrique et/ou une ou plusieurs batteries de stockage de l'électricité ainsi produite ;
- un régulateur, monté sur le circuit électrique de puissance ou d'utilisation, et susceptible d'ouvrir ou de fermer ledit circuit en fonction notamment des paramètres relatifs au fonctionnement de l'installation.

Cette installation se caractérise en ce que le générateur d'énergie électrique est constitué d'un module photovoltaïque du type de celui décrit précédemment.

La manière dont l'invention peut être réalisée et les avantages qui en découlent ressortiront mieux des exemples de réalisation qui suivent donnés à titre indicatif et non limitatif à l'appui des figures annexées.

La figure 1 est une représentation schématique d'une installation conforme à l'invention.

La figure 2 est une représentation d'un schéma électrique simplifié de l'installation selon une première forme de réalisation de l'invention.

La figure 3 est une vue analogue à la figure 2 d'une autre forme de réalisation de l'invention.

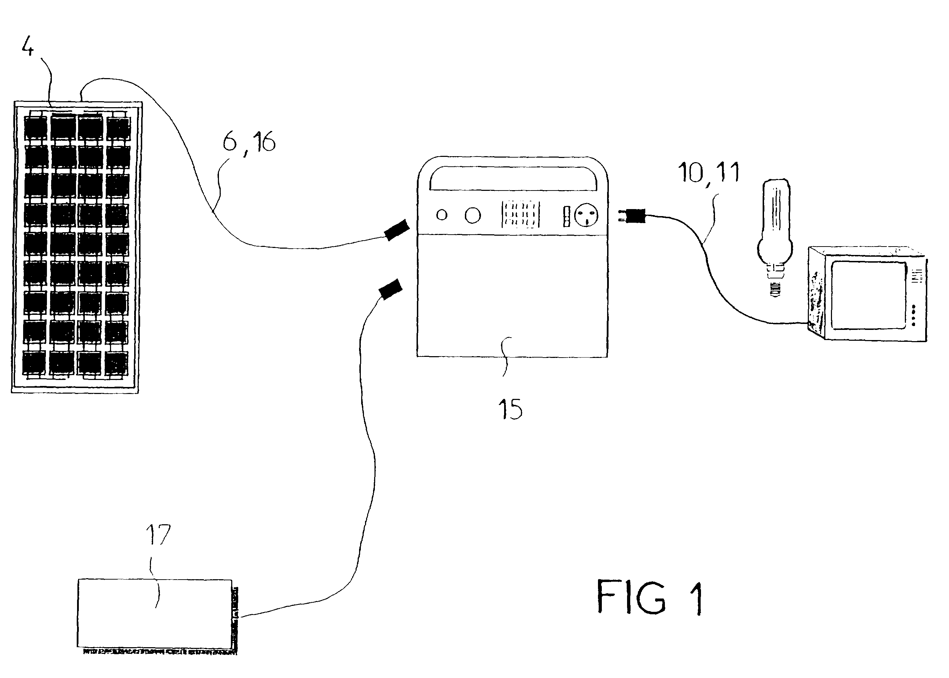

On a schématiquement représenté sur la figure 1, une installation de production d'électricité conforme à l'invention. Cette installation comprend fondamentalement un module de production d'énergie électrique (4), intégrant un module solaire proprement dit, transformant l'énergie solaire en un courant électrique continu, ledit module étant relié par un circuit de puissance (6), notamment à une batterie (15), destinée à stocker l'énergie électrique ainsi produite.

Cette batterie peut en outre, dans certains cas, être également alimentée en énergie par un groupe électrogène d'un type traditionnel (17), via un chargeur de batterie (non représenté).

Peuvent être branchés aux bornes de cette batterie (15) soit un récepteur fonctionnant sous tension continue, par exemple 12 Volts, soit un récepteur fonctionnant sous tension alternative, par exemple 230V, après traitement de la tension par un onduleur.

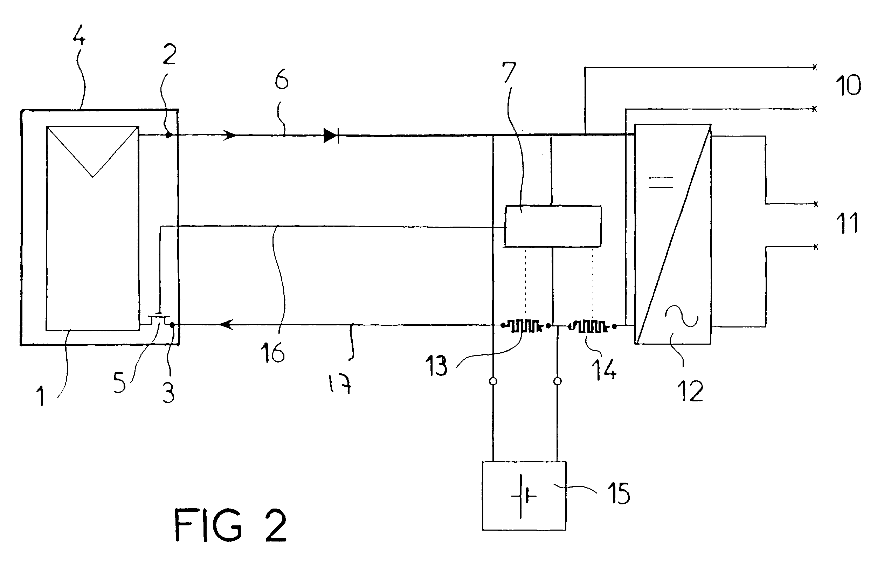

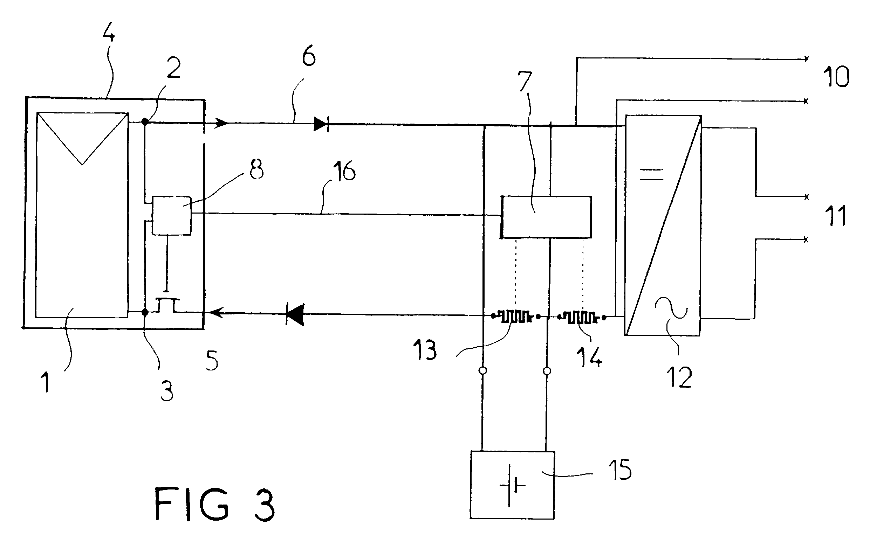

Il convient de se reporter aux figures 2 et 3 pour mieux comprendre l'invention.

Au sein de la figure 2, on a représenté une première forme de réalisation de l'invention. Dans celle-ci, le module photovoltaïque (4) est d'un type en soi connu pour la transformation du rayonnement solaire en courant électrique continu. Ce module comporte deux bornes de puissance (2) et (3), sur l'une desquelles est monté en série un interrupteur, dans le cas d'espèce un transistor à effet de champ (5) réalisé selon la technologie MOS FET.

Selon un particularité de l'invention, ce transistor est intégré dans le module (4) et, par exemple, au dos de la face active de celui-ci, et est coulé dans une résine solidarisée au module, de telle sorte à rendre l'accès impossible audit interrupteur sans aboutir à la destruction de la face active dudit module, et partant sans rendre totalement inutilisable celui-ci.

Dans le montage décrit au sein de la figure 2, le drain et la source du transistor (5) sont connectés sur la borne négative (3) de puissance du module (4). En d'autres termes, le transistor (5) faisant office d'interrupteur est monté en série.

On peut néanmoins concevoir que l'interrupteur soit monté en parallèle, par exemple lorsqu'il est constitué par un relais électro-mécanique, mettant alors en court-circuit les deux bornes de puissances (2) et (3) du module.

Par ailleurs, la grille du transistor (5) est reliée par un circuit de commande (16) à une carte électronique (7) de pilotage de l'installation, elle-même reliée à la batterie (15), et intégrant un dispositif gestionnaire. De fait, ce gestionnaire d'énergie mesure la tension aux bornes de la batterie (15) et, en fonction d'une tension de référence, induit l'ouverture ou la fermeture du transistor (5), c'est à dire la neutralisation dudit module si la tension nominale de la batterie est atteinte.

D'autres paramètres peuvent également intervenir dans la gestion de l'énergie, notamment la température, l'état de charge de la batterie, etc.

On a également représenté, à titre illustratif, un onduleur (12) destiné de manière connue à transformer un courant électrique continu en courant alternatif ainsi que deux sorties d'utilisation, respectivement (10) en courant continu, par exemple 12 Volts, et (11) en courant alternatif, notamment 230 Volts.

On a en outre représenté sous les références (13) et (14) les shunts de mesure au niveau des bornes de la batterie (15), et la mesure de la tension aux bornes de la batterie, susceptibles d'être pris en compte par le gestionnaire d'énergie (9), afin d'assurer la commande de l'interrupteur (5).

De manière connue, la commande d'un transistor à effet de champ s'effectue par tension, mais à un débit de courant pratiquement nul. De la sorte, il ne transite au niveau du circuit de commande (16) que des courants de très faible ampérage.

Dans une autre forme de réalisation de l'invention représentée sur la figure 3, le module (4) intègre non seulement l'interrupteur (5) mais également l'ensemble de traitement (8).

Cet ensemble de traitement (8) est alimenté en énergie directement à partir du module (4) ainsi qu'on peut l'observer, puisqu'il est monté en parallèle aux bornes de puissance (2) et (3) dudit module (1) et en amont de l'interrupteur (5).

En revanche et ainsi que déjà dit, le transistor (5) est monté en série sur l'une des sorties dudit module (4), le reste de l'installation demeurant identique.

Ainsi, dès lors que l'on débranche le module (4) de l'installation de production d'énergie électrique au niveau de laquelle il est mis en place, il n'y a plus alimentation en courant de commande au niveau du circuit de commande (16), de sorte que l'interrupteur (5) ouvre le circuit du module (4). Celui-ci ne peut plus débiter d'énergie, puisque l'interrupteur (5) est bloqué, de sorte qu'il ne peut y avoir sortie de courant en aval de celui-ci.

Par ailleurs, lorsque l'interrupteur est monté en parallèle, celui-ci devient passant, mettant en court-circuit les deux bornes de puissance (2, 3) du module.

Dans l'exemple de réalisation décrit, les signaux de commande transitent par une liaison électrique (16). Ces signaux peuvent être analogiques (courant ou tension) ou numériques (support de transfert du signal : liaison filaire RS 232, RS 422, RS 485, etc.), voire être constitués par des signaux codés, susceptible d'être traités par l'ensemble de traitement (8), gérant le fonctionnement de l'interrupteur (5).

Cependant, le transfert des signaux de commande peut également s'effectuer par ondes hertziennes, la carte électronique de pilotage de l'installation étant connectée à un émetteur, et l'ensemble de traitement (8) étant connecté à un récepteur approprié. De la sorte, il devient possible de s'affranchir des systèmes de câblages du circuit de commande, notamment dans le cadre de panneaux composés d'une pluralité de modules conformes à l'invention.

Dans le même esprit, les signaux de commande peuvent être acheminés par le biais d'ondes porteuses transitant par le circuit de puissance (6, 17). De la sorte, en s'affranchissant du circuit de commande (16), on abouti à la simplification du montage des modules, notamment en cas de pluralité de ceux-ci.

Bien entendu, l'invention s'applique à une installation mettant en oeuvre une pluralité de ces modules (4), ces modules étant susceptibles d'être montés en série ou en parallèle et étant reliés entre eux et au gestionnaire d'énergie au moyen d'un système de câblage assurant le circuit de commande, susceptible d'être remplacé par le circuit de puissance ou par des ondes hertziennes, ainsi que mentionné précédemment.

Dans le cadre d'une installation plus complexe mettant en oeuvre la régulation telle que par exemple décrite en liaison avec les figures 2 et 3, on conçoit donc que la mise en place de cette fonction supplémentaire s'effectue sans réel surcoût en conférant ainsi au système non pas son inviolabilité, mais son caractère dissuasif, attendu que les modules déconnectés ne présentent plus aucune valeur marchande.

En outre, même pour un usage personnel, le module devient inutilisable.

L'interrupteur intégré au module permet d'assurer une fonction de régulation décentralisée, par neutralisation à distance de l'énergie fournie par le ou les modules. De la sorte, il devient possible de standardiser l'électronique de régulation centrale, quelle que soit la puissance du champ photovoltaïque. En effet, on répartit alors la coupure de puissance sur l'ensemble des modules par le biais des interrupteurs intégrés, et ce, sans nécessiter de composants supplémentaires.

Par ailleurs, dans le cadre encore plus évolué d'une installation de fourniture d'énergie électrique d'origine solaire, intégrant par exemple un système de pré-paiement, le dispositif conforme à l'invention permet en cas de tentative de fraude, c'est à dire en cas de branchement illicite en amont du compteur gérant le pré-paiement, d'induire l'interruption immédiate de la fourniture d'énergie par les modules entrant dans la constitution de l'installation en question, par simple blocage ou ouverture des interrupteurs intégrés dans lesdits modules. La commande de blocage ou d'ouverture des interrupteurs peut provenir du compteur lui-même, lorsque le crédit a été épuisé, par le biais du circuit de puissance.

## Revendications

1. Module photovoltaïque, destiné à transformer l'énergie solaire en courant électrique, notamment continu, comprenant un module photovoltaïque proprement dit (4) présentant deux bornes dites de puissance (2, 3), sur lesquelles est connecté directement ou indirectement soit une batterie de stockage (15) de l'énergie électrique ainsi produite, soit un récepteur électrique, voire éventuellement les deux, ***caractérisé*** en ce que le module (4) intègre au sein de sa structure un interrupteur électrique (5), susceptible de neutraliser la puissance disponible en sortie aux bornes de puissance (2, 3) de façon à rendre inutilisable ledit module lorsqu'il a été débranché, ledit interrupteur (5) étant commandé par un circuit de commande (16) depuis l'extérieur du module.

2. Module photovoltaïque selon la revendication 1, ***caractérisé*** en ce que l'interrupteur (5) est noyé dans une résine solidarisée au dos de la face active du panneau (1), c'est à dire de la face exposée au rayonnement solaire, ou est encapsulé au sein de la structure sandwich constitutive dudit module (4), de telle sorte que toute tentative d'extraction de l'interrupteur hors du module revient à le rendre définitivement inutilisable.

3. Module photovoltaïque selon l'une des revendications 1 et 2, ***caractérisé*** en ce que l'interrupteur (5) est un interrupteur électronique du type transistor à effet de champ réalisé selon la technologie MOS-FET.

4. Module photovoltaïque selon l'une des revendications 1 et 2, ***caractérisé*** en ce que l'interrupteur (5) est un relai électromécanique.

5. Module photovoltaïque selon l'une des revendications 1 à 4, ***caractérisé*** en ce que le module (4) intègre en outre un ensemble de traitement (8), monté en parallèle aux bornes (2, 3) du module, et en amont de l'interrupteur (5) de telle sorte à être alimenté par l'énergie électrique produite par le module (4), et destiné à recevoir des signaux de commande sous forme analogique, numérique, codés ou non, de telle sorte à gérer le fonctionnement de l'interrupteur (5) en vue de son ouverture ou de sa fermeture.

6. Module photovoltaïque selon la revendication 5, ***caractérisé*** en ce que l'ensemble de traitement (8) est noyé dans une résine solidarisée au dos, de la face active du module (4), c'est à dire de la face exposée au rayonnement solaire.

7. Module photovoltaïque selon l'une des revendications 5 et 6, ***caractérisé*** en ce que les signaux de commande sont transmis à l'ensemble de traitement (8) par ondes hertziennes.

8. Module photovoltaïque selon l'une des revendications 1 à 6, ***caractérisé*** en ce que le circuit de commande est constitué par le circuit de puissance (6, 17) émanant de ses bornes de puissance (2, 3), les signaux de commande transitant sur ledit circuit de puissance par ondes porteuses.

9. Installation de production d'énergie électrique comprenant :
- au moins un générateur d'énergie électrique ;
- un circuit électrique de puissance ou d'utilisation (6, 17), comprenant au moins un récepteur électrique et/ou une ou plusieurs batteries de stockage (15) de l'électricité ainsi produite ;
- un régulateur (7, 8), monté sur le circuit électrique de puissance ou d'utilisation, et susceptible d'ouvrir ou de fermer ledit circuit en fonction notamment des paramètres relatifs au fonctionnement de l'installation,
***caractérisée*** en ce que le générateur d'énergie électrique est constitué d'un module photovoltaïque (4) selon l'une des revendications 1 à 7.

10. Installation de production d'énergie électrique selon la revendication 9, ***caractérisée*** en ce qu'elle intègre sur le circuit de puissance un compteur d'énergie électrique, fonctionnant selon le principe du pré-paiement, et susceptible d'induire le blocage ou l'ouverture de l'interrupteur intégré dans chacun des panneaux constitutifs de ladite installation dès épuisement de la quantité d'électricité allouée en contrepartie du pré-paiement, de telle sorte à induire l'interruption de la fourniture d'énergie électrique.

## Patentansprüche

1. Photovoltaisches Modul, welches dazu bestimmt ist, Sonnenenergie in elektrischen Strom, insbesondere Gleichstrom, umzuwandeln, und ein eigentliches photovoltaisches Modul (4) umfaßt, das zwei sogenannte Leistungsklemmen (2, 3) aufweist, an denen direkt oder indirekt entweder eine Batterie (15) zur Speicherung der so erzeugten elektrischen Energie oder ein elektrischer Verbraucher oder gegebenenfalls beides angeschlossen ist, **dadurch gekennzeichnet,** daß innerhalb der Struktur des Moduls (4) ein elektrischer Schalter (5) integriert ist, welcher die am Ausgang verfügbare Leistung an den Leistungsklemmen (2, 3) neutralisieren kann, um so das genannte Modul funktionsunfähig zu machen, wenn es abgeklemmt wurde, wobei der genannte Schalter (5) durch einen Steuerschaltkreis (16) von außerhalb des Moduls aus gesteuert wird.

2. Photovoltaisches Modul nach Anspruch 1, **dadurch gekennzeichnet,** daß der Schalter (5) in ein Harz eingebettet ist, welches mit der Rückseite der aktiven Fläche, das heißt der der Sonnenstrahlung ausgesetzten Fläche der Platte (1) fest verbunden ist, oder daß er innerhalb der das genannte Modul (4) bildenden Sandwich-Struktur eingekapselt ist, so daß jeder Versuch der Entfernung des Schalters aus dem Modul dieses letztendlich endgültig funktionsunfähig macht.

3. Photovoltaisches Modul nach einem der Ansprüche 1 und 2, **dadurch gekennzeichnet,** daß der Schalter (5) ein nach der MOS-FET-Technologie hergestellter elektronischer Schalter nach Art eines Feldeffekttransistors ist.

4. Photovoltaisches Modul nach einem der Ansprüche 1 und 2, **dadurch gekennzeichnet,** daß der Schalter (5) ein elektromechanisches Relais ist.

5. Photovoltaisches Modul nach einem der Ansprüche 1 bis 4, **dadurch gekennzeichnet,** daß in das Modul (4) außerdem eine Datenverarbeitungseinheit (8) integriert ist, welche parallel zu den Klemmen (2, 3) des Moduls und vor den Schalter (5) geschaltet ist, so daß sie mit der von dem Modul (4) erzeugten elektrischen Energie gespeist wird, und welche dazu bestimmt ist, Steuersignale in analoger, digitaler, kodierter oder nicht kodierter Form zu empfangen, so daß sie die Funktion des Schalters (5) hinsichtlich seines Öffnens oder seines Schließens steuert.

6. Photovoltaisches Modul nach Anspruch 5, **dadurch gekennzeichnet,** daß die Datenverarbeitungseinheit (8) in ein Harz eingebettet ist, welches mit der Rückseite der aktiven Fläche, das heißt der der Sonnenstrahlung ausgesetzten Fläche des Moduls (4) fest verbunden ist.

7. Photovoltaisches Modul nach einem der Ansprüche 5 und 6, **dadurch gekennzeichnet,** daß die Steuersignale an die Datenverarbeitungseinheit (8) mittels hertzscher Wellen übertragen werden.

8. Photovoltaisches Modul nach einem der Ansprüche 1 bis 6, **dadurch gekennzeichnet,** daß der Steuerschaltkreis aus dem Energieschaltkreis (6, 17) besteht, der von seinen Leistungsklemmen (2, 3) ausgeht, wobei die Steuersignale durch Trägerwellen auf den genannten Energieschaltkreis übergehen.

9. Anlage zur Erzeugung elektrischer Energie, welche folgendes umfaßt:
- mindestens einen Generator für elektrische Energie;
- einen elektrischen Energie- oder Verbraucherstromkreis (6, 17), welcher mindestens einen elektrischen Verbraucher und/oder eine oder mehrere Batterien (15) zur Speicherung der so erzeugten Energie umfaßt;
- einen auf den elektrischen Energie- oder Verbraucherstromkreis geschalteten Regler (7, 8), welcher den genannten Kreis insbesondere in Abhängigkeit von den Parametern in bezug auf die Funktion der Anlage öffnen oder schließen kann,
**dadurch gekennzeichnet,** daß der Generator für elektrische Energie aus einem photovoltaischen Modul (4) nach einem der Ansprüche 1 bis 7 besteht.

10. Anlage zur Erzeugung elektrischer Energie nach Anspruch 9, **dadurch gekennzeichnet,** daß in den Energiekreis ein elektrischer Stromzähler integriert ist, der nach dem Prinzip der vorherigen Bezahlung funktioniert und das Blockieren oder das Öffnen des in jede der die genannte Anlage bildenden Platten integrierten Schalters bewirken kann, sobald die als Gegenleistung für die vorherige Bezahlung bereitgestellte Elektrizitätsmenge aufgebraucht ist, so daß er die Unterbrechung der Abgabe elektrischer Energie bewirkt.

## Claims

1. Photovoltaic module intended to convert solar power into electrical current, especially DC current, comprising a photovoltaic module proper (4) having two terminals called power terminals (2, 3), either a battery (15) for storing the electrical energy thus produced or an electrical receiver, or possibly even both, being connected directly or indirectly to these terminals, ***characterized*** in that the module (4) incorporates into its structure an electrical switch (5) which is capable of neutralizing the available power output at the power terminals (2, 3) in order to render said module unusable when the later is disconnected, said switch (5) being controlled by a control circuit (16) from outside the module.

2. Photovoltaic module according to Claim 1, ***characterized*** in that the switch (5) is embedded in a resin made integral with the back of the active face of the panel (1), that is to say of the face exposed to the solar radiation, or is encapsulated within the sandwich structure making up the said module (4), in such a way that any attempt to remove the switch from the module results in it becoming permanently unusable.

3. Photovoltaic module according to either of Claims 1 and 2, ***characterized*** in that the switch (5) is an electronic switch of the field-effect transistor type produced in MOSFET technology.

4. Photovoltaic module according to either of Claims 1 and 2, ***characterized*** in that the switch (5) is an electromechanical relay.

5. Photovoltaic module according to one of Claims 1 to 4, ***characterized*** in that the module (4) furthermore incorporates a processing unit (8) which is mounted in parallel with the terminals (2, 3) of the module, and upstream of the switch (5), in such a way as to be supplied by the electrical energy produced by the module (4), and which is intended to receive coded or uncoded control signals of the analog or digital form, in such a way as to manage the operation of the switch (5) for the purpose of opening or closing it.

6. Photovoltaic module according to Claim 5, ***characterized*** in that the processing unit (8) is embedded in a resin made integral with the back of the active face of the module, that is to say of the face exposed to the solar radiation.

7. Photovoltaic module according to either of Claims 5 and 6, ***characterized*** in that the control signals are transmitted to the processing unit (8) by radiowaves.

8. Photovoltaic module according to one of Claims 1 to 6, ***characterized*** in that the control circuit consists of the power circuit (6, 17) emerging from its power terminals (2, 3), the control signals being conveyed in the said power circuit by carrier waves.

9. Electrical energy production unit comprising:
- at least one electrical energy generator;
- an electrical power or use circuit (6,17) comprising at least one electrical receiver and/or one or more batteries (15) for storing the electricity thus produced;
- a regulator (7, 8) mounted in the electrical power or use circuit and capable of opening or closing the said circuit depending especially on the parameters relating to the operation of the unit;
***characterized*** in that the electrical energy generator consists of a photovoltaic module (4) according to one of Claims 1 to 7.

10. Electrical energy production unit according to Claim 9, ***characterized*** in that it incorporates in the power circuit an electrical power meter which operates according to the prepayment principle and which is capable of turning off or opening the switch, incorporated into each of the panels making up the said unit, as soon as the allocated amount of electricity corresponding to the prepayment is consumed, in such a way as to cause the electrical energy supply to be interrupted.
